# EUROPÄISCHE PATENTSCHRIFT

(11) **EP 3 871 245 B1**
(45) Veröffentlichungstag und Bekanntmachung des Hinweises auf die Patenterteilung: **19.10.2022**
(21) Anmeldenummer: 19794940.7
(22) Anmeldetag: 22.10.2019
(51) Int. Cl.: H01J 37/32, C23C 16/455

(54) **CVD-REAKTOR, SCHIRMPLATTE FÜR EINEN CVD-REAKTOR UND VERFAHREN ZUR BEEINFLUSSUNG DER TEMPERATUR EINER SCHIRMPLATTE**
CVD REACTOR, SHIELD PLATE FOR A CVD REACTOR AND METHOD OF INFLUENCING THE TEMPERATURE OF A SHIELD PLATE
RÉACTEUR CVD, PLAQUE FORMANT ÉCRAN POUR UN RÉACTEUR CVD ET PROCÉDÉ POUR INFLUENCER LA TEMPÉRATURE D'UNE PLAQUE FORMANT ÉCRAN

(30) Priorität: 25.10.2018 DE 102018126617
(43) Veröffentlichungstag der Anmeldung: 01.09.2021
(73) Patentinhaber: Aixtron SE, 52134 Herzogenrath (DE)
(72) Erfinder: BOYD, Adam, 4721 Kelmis (BE); KRÜCKEN, Wilhelm Josef Thomas, 52076 Aachen (DE); JIANG, Honggen, Cornwall PE27 3FN (GB); CRAWLEY, Fred Michael Andrew, Royston Hertfordshire SG8 5QN (GB)
(74) Vertreter: Grundmann, Dirk
(86) Internationale Anmeldenummer: PCT/EP2019/078738
(87) Internationale Veröffentlichungsnummer: WO 2020/083917

(56) Entgegenhaltungen:
- WO-A1-2011/004712
- KR-A- 20080 112 437
- US-A1- 2005 011 447
- US-A1- 2015 179 405

## Beschreibung

### Gebiet der Technik

Die Erfindung betrifft einen CVD-Reaktor mit einem einen kreisförmigen Grundriss aufweisenden Gaseinlassorgan, welches eine zu einer Prozesskammer weisende, gekühlte Deckenplatte und einen von einer Heizeinrichtung beheizbaren Suszeptor aufweist, wobei die Deckenplatte Austrittsöffnungen aufweist, und mit einer an die Deckenplatte angrenzenden, einen kreisförmigen Grundriss aufweisenden Schirmplatte, die eine Zentralzone, eine die Zentralzone umgebende Ringzone, eine zur Deckenplatte weisenden Rückseite und eine erste, ebene, zur Prozesskammer weisende Gasaustrittsfläche, in die Gasaustrittsöffnungen münden, aufweist, wobei die Rückseite in der Zentralzone eine parallel zur Gasaustrittsfläche verlaufende Rückseitenebene definiert und wobei die Rückseite Strukturen aufweist zur Beeinflussung der thermischen Ankopplung der Schirmplatte an die Deckenplatte und/oder zur Beeinflussung des Wärmeflusses durch die Schirmplatte, welche Strukturen zumindest eine Erhebung und/oder eine Vertiefung gegenüber der Rückseitenebene ausbilden

Die Erfindung betrifft darüber hinaus eine Schirmplatte zur Verwendung in einem CVD-Reaktor.

Die Erfindung betrifft ferner ein Verfahren zur Beeinflussung der Temperatur einer zu einer Prozesskammer weisenden ersten Gasaustrittsfläche einer zwischen einer gekühlten Deckenplatte eines CVD-Reaktors angeordneten, einen kreisförmigen Grundriss aufweisenden Schirmplatte, die eine Zentralzone, eine die Zentralzone umgebende Ringzone, eine zur Deckenplatte weisenden Rückseite und eine erste, ebene, zur Prozesskammer weisende Gasaustrittsfläche, in die Gasaustrittsöffnungen münden, aufweist, wobei die Rückseite in ihrer Zentralzone eine parallel zur Gasaustrittsfläche verlaufende Rückseitenebene definiert und wobei ein von einer Heizeinrichtung beheizter Suszeptor zumindest ein Substrat trägt, das wärmebehandelt wird, wobei ein Wärmefluss vom Suszeptor zur Deckenplatte erzeugt wird, wobei die thermische Ankopplung der Schirmplatte an die Deckenplatte und/oder der Wärmefluss durch die Schirmplatte mittels auf der Rückseite der Schirmplatte angeordneten Strukturen beeinflusst wird, wobei die Strukturen zumindest eine Erhebung und/oder eine Vertiefung gegenüber der Rückseitenebene der ausbilden.

### Stand der Technik

Eine gattungsgemäße Vorrichtung wird in der DE 10 2012 110 125 A1 beschrieben. Der dort beschriebene CVD-Reaktor beziehungsweise das dort beschriebene Verfahren zum Abscheiden von dünnen Halbleiterschichten auf Halbleitersubstraten weist ein Gaseinlassorgan auf, durch welches ein Prozessgas in eine Prozesskammer eingespeist wird. Unterhalb einer Gasaustrittsfläche einer Bodenplatte des Gaseinlassorganes erstreckt sich eine Schirmplatte mit zu den Gasaustrittsöffnungen der Bodenplatte fluchtenden Gasdurchtrittskanälen. Auf einem beheizten Substrat liegen die zu beschichtenden Substrate auf.

Vorrichtungen dieser Art sind darüber hinaus bekannt aus den KR 2008 0112437 A, US 2015/179405 A1, WO 2011/004712 A1, US 2005/011447 A1, KR 101373746, US 6,793,733 B2 und US 9,587,312 B2.

Aus der US 2010/0003824 A1 ist darüber hinaus eine unterhalb einer Gasaustrittsplatte eines Gaseinlassorganes angeordnete Platte vorgesehen, die im Randbereich eine Verjüngung aufweist.

Bei einer Vorrichtung der eingangs genannten Art beziehungsweise bei einem Verfahren der eingangs genannten Art wird beobachtet, dass sich an der Unterseite der Schirmplatte, also der zur Prozesskammer weisenden und die Prozesskammer begrenzenden Gasaustrittsfläche, aus der das Prozessgas in die Prozesskammer strömt, ein nicht homogenes laterales Temperaturprofil ausbildet. Bei einem gattungsgemäßen Verfahren wird der die Substrate tragende Suszeptor, der die Prozesskammer nach unten hin begrenzt, von unten her auf eine Suszeptortemperatur von beispielsweise mehr als 1.000°C aufgeheizt. Die Deckenplatte wird aktiv gekühlt. Als Folge dessen bildet sich ein Wärmefluss vom Suszeptor durch die Prozesskammer und durch die Schirmplatte zur gekühlten Deckenplatte aus. Die Temperatur der zur Prozesskammer weisenden Gasaustrittsfläche der Schirmplatte wird im Wesentlichen durch die lokale Wärmestrahlungsleistung der Suszeptoroberfläche beziehungsweise Substratoberfläche beeinflusst. Diese kann lokal variieren, so dass auch die Oberflächentemperatur der Schirmplatte lokal variieren kann.

Für eine gleichmäßige und prozessstabile Beschichtung der Substrate mit dünnen insbesondere Halbleiterschichten ist es aber erforderlich, dass die zur Prozesskammer weisende Fläche der Schirmplatte möglichst geringe lokale Temperaturunterschiede aufweist.

Die JP 2010-232402 A beschreibt einen CVD-Reaktor, bei dem unterhalb einer Gasaustrittsplatte eines Gaseinlassorganes eine weitere Platte angeordnet ist, die fest mit dem Gaseinlassorgan verbunden ist. Die Randbereiche der Platte stehen radial über und besitzen ein keilförmiges Profil.

Ein Gaseinlassorgan mit einer Schirmplatte, die durch einen Spalt von einer Gasaustrittsfläche des Gaseinlassorganes beabstandet ist, zeigt die DE 10 2012110125 A1.

### Zusammenfassung der Erfindung

Der Erfindung liegt somit die Aufgabe zugrunde, Mittel anzugeben, mit denen sich das Temperaturprofil einer Prozesskammerdecke lokal beeinflussen lässt.

Gelöst wird die Aufgabe durch die in den Ansprüchen angegebene Erfindung, wobei die Unteransprüche nicht nur vorteilhafte Weiterbildungen der in den nebengeordneten Ansprüchen angegebenen Erfindung, sondern auch eigenständige Lösungen der Aufgabe darstellen.

Zunächst und im Wesentlichen wird vorgeschlagen, dass die Schirmplatte auf ihrer zur Deckenplatte weisenden Rückseite Strukturen aufweist, die derart ausgebildet sind, dass sie eine thermische Ankopplung und/oder den Wärmefluss durch die Schirmplatte lokal unterschiedlich beeinflussen. Die Rückseite der Deckenplatte kann Zonen aufweisen, die aneinander angrenzen und unterschiedlich thermisch aneinander angekoppelt sind. Die Zonen können aber auch derart ausgebildet sein, dass der Wärmefluss von der Gasaustrittsfläche zur Rückseite der Schirmplatte in voneinander verschiedenen Zonen unterschiedlich ist. Mit den Strukturen lässt sich die thermische Ankopplung zwischen den einzelnen Zonen oder die thermische Ankopplung der Schirmplatte an die Deckenplatte beeinflussen. Mit einer derartigen Gestaltung einer Schirmplatte lässt sich somit die Oberflächentemperatur der von der Gasaustrittsfläche gebildeten Prozesskammerdecke lokal beeinflussen, um laterale Temperaturgradienten in der Gasaustrittsfläche zu minimieren, die durch lokal verschiedene Wärmestrahlungsleistungen vom Suszeptor her verursacht werden. In Ausführungsbeispielen der Erfindungen kann vorgesehen sein, dass die Deckenplatte von einem Gaseinlassorgan gebildet wird. Das Gaseinlassorgan kann ein oder mehrere Gasverteilkammern aufweisen, die von außen her durch eine Gaszuleitung gespeist werden. Die zumindest eine innerhalb des Gaseinlassorganes angeordnete Gasverteilkammer ist mit Gasdurchtrittskanälen mit einer zweiten Gasaustrittsfläche verbunden. Die zweite Gasaustrittsfläche wird von der Bodenplatte ausgebildet. Es kann darüber hinaus vorgesehen sein, dass an die Deckenplatte unmittelbar eine Kühlmittel-Aufnahmekammer angrenzt. Es kann aber auch vorgesehen sein, dass die Deckenplatte Kühlkanäle aufweist oder Bestandteil eines Kühlkörpers ist. Die Gasdurchtrittskanäle des Gaseinlassorganes münden in der Deckenplatte. Es ist eine Vielzahl von siebartig angeordneten Gasauslassöffnungen in der Deckenplatte vorgesehen, die jeweils von einem Gasdurchtrittskanal gespeist werden. Es kann ferner vorgesehen sein, dass die Schirmplatte von der Deckenplatte beabstandet ist. Es ist somit insbesondere ein Spalt zwischen der Rückseite der zweiten Gasaustrittsfläche vorgesehen, die von der Deckenplatte ausgebildet ist. Dieser Spalt kann eine Spalthöhe von maximal 20 mm aufweisen. Es ist bevorzugt vorgesehen, dass die Spalthöhe maximal 2 mm beträgt und insbesondere in einem Bereich zwischen 0,3 und 1 mm liegt. Es kann ferner vorgesehen sein, dass eine von der Schirmplatte ausgebildete erste Gasaustrittsfläche, welche die Prozesskammer begrenzt, in einer Ebene verläuft. Ferner kann vorgesehen sein, dass die Schirmplatte eine Materialstärke von 3 bis 10 mm aufweist. Es kann vorgesehen sein, dass die den Wärmefluss durch die Schirmplatte lokal beeinflussenden Strukturen durch Zonen verschiedener Materialstärken der Schirmplatte ausgebildet sind, wobei die mittlere Materialstärke der Schirmplatte im Bereich zwischen 5 mm und 7,5 mm liegen kann. Es kann vorgesehen sein, dass die Strukturen Vertiefungen oder Erhebungen gegenüber einer mittleren, maximalen oder minimalen Materialstärke sind, wobei vorgesehen sein kann, dass die Erhebungen bevorzugt von Zonen mit einer Materialstärke gebildet sind, die maximal um 1 mm von der minimalen oder maximalen Materialstärke abweicht oder dass die Vertiefungen von Zonen gebildet sind, bei denen die Materialstärke um maximal 1 mm von einer maximalen oder mittleren Materialstärke abweicht. Es kann ferner vorgesehen, dass die den Wärmefluss durch die Schirmplatte lokal beeinflussenden Zonen voneinander verschiedene Oberflächeneigenschaften aufweisen, wobei insbesondere vorgesehen ist, dass die Oberflächen verschiedene Wärmeemissivitäten aufweisen. Es ist auch vorgesehen, dass diese Zonen verschiedene Wärmeleitfähigkeiten aufweisen, beispielsweise dass sich die Materialeigenschaft der Schirmplatte lokal ändert. Die Zonen voneinander verschiedenen Wärmeflusses durch die Schirmplatte können lokal den Zonen zugeordnet sein, auf denen sich auf dem Suszeptor zu beschichtende Substrate befinden. Bei einem drehbaren Suszeptor können die Zonen ringförmig um das Drehzentrum angeordnet sein. In einer bevorzugten Ausgestaltung der Erfindung ist jedoch vorgesehen, dass die Schirmplatte zur Beeinflussung des lateralen Temperaturprofils lediglich im Randbereich eine zum Rand hin abfallende Materialstärke besitzt. Die Schirmplatte besitzt somit erfindungsgemäß eine randseitige Verjüngung. Die randseitige Verjüngung wird bevorzugt durch einen keilförmigen Abschnitt im Randbereich ausgebildet, wobei die bevorzugt im Wesentlichen einen kreisrunden Querschnitt aufweisende Schirmplatte eine ebene Gasaustrittsfläche aufweist. Die ersten Gasdurchtrittsöffnungen der Schirmplatte können mit den zweiten Gasdurchtrittsöffnungen der Deckenplatte fluchten. Es ist aber auch vorgesehen, dass die ersten Gasdurchtrittsöffnungen zu den zweiten Gasdurchtrittsöffnungen zumindest teilweise versetzt angeordnet sind.

Bei dem in der zuvor beschriebenen Vorrichtung durchgeführten Verfahren handelt es sich bevorzugt um ein Verfahren zum Abscheiden von Halbleiterschichten auf Halbleitersubstraten. Als Substrate können Saphirsubstrate, Siliziumsubstrate, aber auch III-V-Substrate verwendet werden. Die durch das Gaseinlassorgan in die Prozesskammer eingeleiteten Prozessgase enthalten bevorzugt Hydride von Elementen der V-Hauptgruppe und metallorganische Verbindungen von Elementen der III-Hauptgruppe. Bevorzugt wird in der Vorrichtung zumindest eine GaN-Schicht abgeschieden.

Die Erfindung betrifft darüber hinaus eine mit lokalen Strukturen versehene Schirmplatte zur Verwendung in einer derartigen Vorrichtung oder in einem derartigen Verfahren.

Die maximale Tiefe der Vertiefung oder die maximale Höhe der Erhöhung bemisst sich an einer Rückseitenebene und kann 0,3 bis 1,2 mm betragen. Die Rückseitenebene wird von der Rückseite der Schirmplatte definiert. Bevorzugt definiert die Zentralzone der Rückseite die Rückseitenebene. Besitzt die Zentralzone keine Erhebungen oder Vertiefungen, sondern verläuft eben, so wird die Rückseitenebene von der Rückseitenfläche der Zentralzone definiert. Besitzt die Zentralzone der Rückseite hingegen Vertiefungen oder Erhöhungen, so definiert der die Vertiefungen oder Erhöhungen umgebende ebene Bereich der Rückseite die Rückseitenebene. Die Rückseitenebene kann somit durch den flächenmäßig größten in einer einzigen Ebene verlaufenden Bereich der Rückseite definiert sein. Die Materialstärke, also die Dicke der Schirmplatte wird von einem Abstand zwischen der sich in einer Ebene erstreckenden Gasaustrittsfläche und der Rückseitenebene definiert. Bevorzugt verläuft die Gasaustrittsfläche parallel zur Rückseitenebene, so dass die Vertiefungen oder Erhöhungen lokale Abweichungen von der ansonsten konstanten Materialstärke der Schirmplatte sind. Der radial äußere Rand der Schirmplatte bildet eine Überstromkante aus, über welche in den Spalt eingespeistes Prozessgas strömen kann die Überstromkante grenzt an einen Ringspalt zu einem Begrenzungselement, das von einer Seitenwand ausgebildet ist, die den durch den Ringspalt tretenden Gasstrom in einen Gasauslassring leiten kann.

### Kurze Beschreibung der Zeichnungen

Ausführungsbeispiele der Erfindung werden nachfolgend anhand beigefügter Zeichnungen erläutert. Es zeigen:
- Fig. 1: schematisch einen CVD-Reaktor 1 mit einem darin angeordneten Gaseinlassorgan 2 und einem Suszeptor 3, wobei sich zwischen Gaseinlassorgan 2 und Suszeptor 3 eine Schirmplatte 10 befindet, die eine Prozesskammer 11 nach oben hin begrenzt,
- Fig. 2: vergrößert den Ausschnitt II in Figur 1,
- Fig. 3: vergrößert den Ausschnitt III in Figur 2,
- Fig. 4: eine Darstellung des Eingerichtes eines CVD-Reaktors 1 gemäß Figur 1, jedoch mit einer Schirmplatte 10 eines zweiten Ausführungsbeispiels und
- Fig. 5: eine Darstellung gemäß Figur 4 mit einer Schirmplatte 10 eines dritten Ausführungsbeispiels.

### Beschreibung der Ausführungsformen

Der CVD-Reaktor 1 besteht aus einem gasdichten und druckdichten Edelstahlgehäuse. Durch einen Gaseinlass 6 kann ein in einem Inertgas transportiertes Prozessgas in eine Gasverteilkammer 2' eines Gaseinlassorganes 2 eingespeist werden. Das Gaseinlassorgan 2 kann auch mehrere Gasverteilkammern 2' aufweisen, so dass voneinander verschiedene Prozessgase in voneinander verschiedene Gasverteilkammern 2' eingespeist werden können. Beim Ausführungsbeispiel ist der Einfachheit halber lediglich eine Gasverteilkammer 2' dargestellt. Aus der Gasverteilkammer 2' kann das Prozessgas durch eine Vielzahl von duschkopfartig angeordneten Gasdurchtrittskanälen 12 austreten. Die Gasdurchtrittskanäle 12 besitzen zwei voneinander wegweisende Öffnungen. Eine Gaseintrittsöffnung 12" grenzt an das Gasverteilvolumen 2' und eine Gasaustrittsöffnung 12' grenzt an eine Gasaustrittsfläche 8' einer Deckenplatte 8 des Gaseinlassorganes 2 an.

Die Deckenplatte 8 bildet eine Gasaustrittsfläche 8' aus, in der die Gasaustrittsöffnungen 12' münden. Auf der der Gasaustrittsfläche 8' abgewandten Seite befindet sich eine Kühlmittel-Aufnahmekammer 13, durch die ein Kühlmittel, beispielsweise Kühlwasser, hindurchströmen kann, um die von der Deckenplatte 8 ausgebildete Gasaustrittsplatte auf Temperaturen unter 300°C, unter 200°C und insbesondere auf ca. 100°C oder weniger zu kühlen.

In dem Reaktorgehäuse 1 befindet sich eine Heizeinrichtung 4, die eine RF-Heizung oder IR-Heizung oder dergleichen sein kann. In dieser Heizeinrichtung 4 wird ein insbesondere aus beschichtetem Graphit bestehender Suszeptor 3 auf eine Suszeptortemperatur von beispielsweise über 1000°C aufgeheizt. Auf einer zur Prozesskammer 11 weisenden Oberseite des Suszeptors 3 befinden sich ein oder mehrere mit einer dünnen Schicht zu beschichtende Substrate 9.

Die Prozesskammer 11 wird nach oben hin durch eine Schirmplatte 10 aus beispielsweise Graphit und insbesondere beschichtetem Graphit begrenzt. Die Schirmplatte 10 kann aber auch aus einem keramischen Material oder aus Quarz bestehen. Die Schirmplatte 10 weist einen kreisrunden Grundriss auf. Der Suszeptor 3 kann etwa dieselbe Größe wie die Deckenplatte 10 aufweisen und besitzt ebenfalls bevorzugt einen kreisförmigen Grundriss.

Die Schirmplatte 10 besitzt eine Vielzahl von Gasdurchtrittsöffnungen 15. Eine nach oben weisende Öffnung 15' des Gasdurchtrittskanals 15 weist zu einem Spalt 17 zwischen der Gasaustrittsfläche 8' der Deckenplatte 8. Eine davon wegweisende Öffnung 15' bildet eine Gasaustrittsöffnung zum Austritt des von dem Inertgas transportierten Prozessgases in die an eine Gasaustrittsfläche 14 angrenzende Prozesskammer 11. Eine Rückseite 16 der Schirmplatte 10 liegt somit um eine Spalthöhe S von der Gasaustrittsfläche 8' der Deckenplatte 8 beabstandet.

Es bilden sich somit eine erste, in einer Ebene verlaufende Gasaustrittsfläche 14 und eine zweite ebenfalls in einer Ebene verlaufende Gasaustrittsfläche 8' aus. Mit der Bezugsziffer 7 ist ein ringförmiges Begrenzungselement bezeichnet, welches auch als Strömungsleitmittel wirken kann, um das in die Prozesskammer eingespeiste Prozessgas über den Rand des Suszeptors 3 hin zu einem Gasauslass 5 zu leiten, an dem eine nicht dargestellte Vakuumpumpe und eine Gasreinigungseinrichtung angeschlossen ist.

Das Begrenzungselement 7 kann am Gaseinlassorgan 2 befestigt sein.

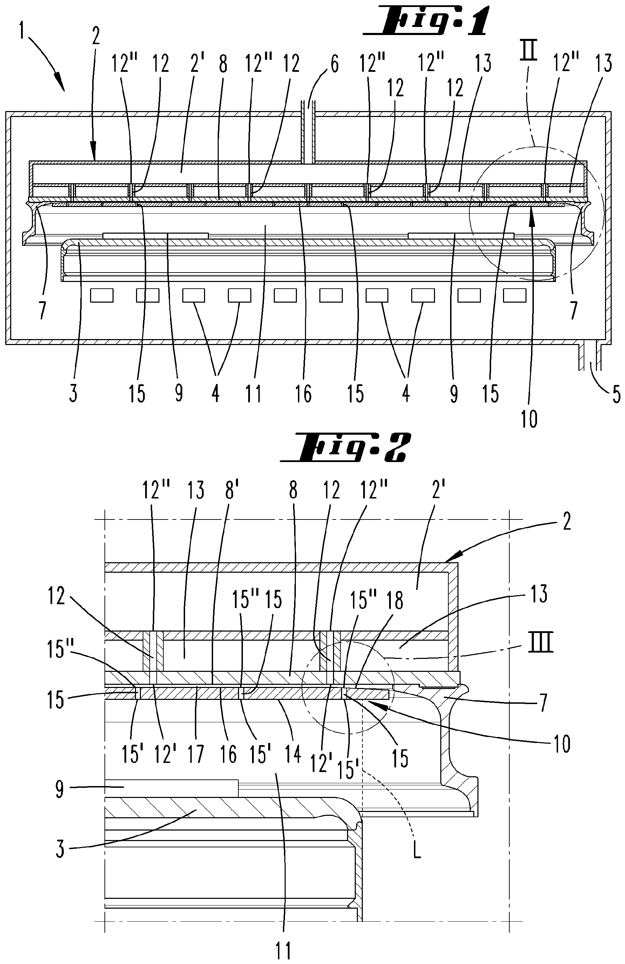

Bei dem in den Figuren 1 bis 3 dargestellten ersten Ausführungsbeispiel ist die Rückseite 16 der Schirmplatte 10 bis auf einen Randbereich 18 eben ausgebildet. Im Zentralbereich radial innerhalb des Randbereichs 18 besitzt die Schirmplatte 10 somit eine gleichbleibende Materialstärke im Bereich zwischen 5 mm und 7,5 mm. Sie ist in diesem Bereich um die Spalthöhe S von etwa 0,5 mm von der Deckenplatte 8 beabstandet.

Im Randbereich 18 verjüngt sich die Materialstärke der Schirmplatte 10 unter Ausbildung einer keilförmigen Ringschräge zum radial äußersten Rand hin. Hierdurch formt der Randbereich 18 eine Vertiefung und eine Zone mit einer unterschiedlichen Wärmetransporteigenschaft durch die Schirmplatte 10. Die Temperatur des Randes der Schirmplatte 10 kann dadurch beeinflusst und insbesondere erhöht werden.

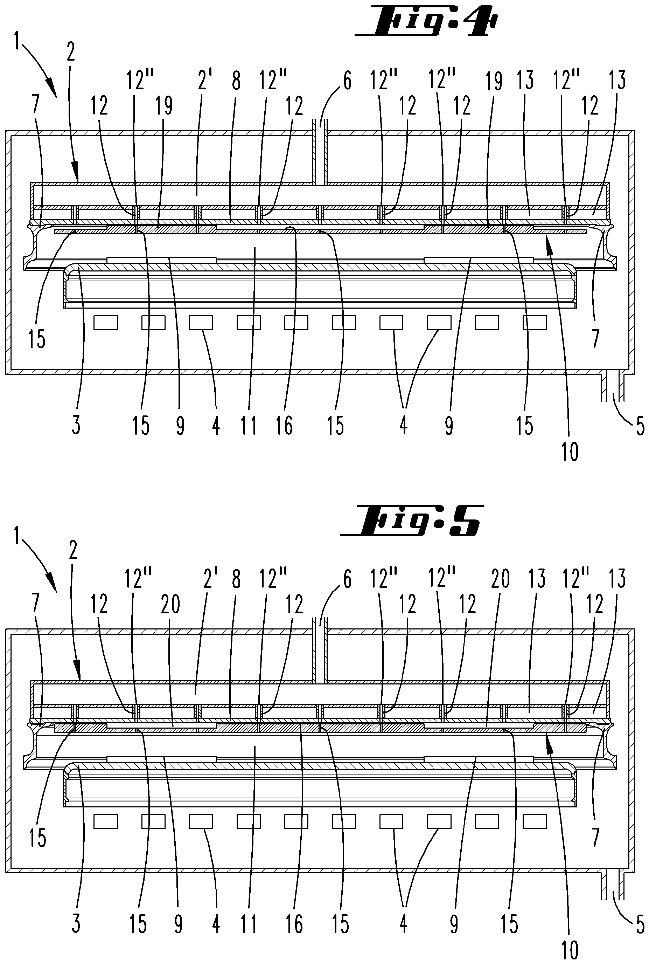

Bei dem in der Figur 4 dargestellten Ausführungsbeispiel erstreckt sich die Gasaustrittsfläche 14 der Schirmplatte 10 ebenfalls in einer Ebene. Die Rückseite 16 erstreckt sich im Wesentlichen ebenfalls in einer Parallelebene dazu. Die Rückseite 16 besitzt jedoch Zonen 19, die von lokalen Erhebungen ausgebildet sind. Im Bereich der lokalen Erhebungen 19 besitzt die Schirmplatte 10 eine größere Materialstärke als in dem die Erhebungen 19 umgebenden Bereich.

Bei dem in der Figur 5 dargestellten Ausführungsbeispiel sind anstelle der in der Figur 4 dargestellten Erhebungen 19 Vertiefungen 20 vorgesehen. Die Vertiefungen 20 in Figur 5 beziehungsweise die Erhebungen 19 in Figur 4 können kreisförmig sein.

Die Vertiefungen 20 beziehungsweise Erhebungen 19 in den in den Figuren 4 und 5 dargestellten Ausführungsbeispielen befinden sich an den Orten, wo unterhalb der Schirmplatte 10 Substrate 9 auf dem Suszeptor 3 angeordnet sind.

Bei allen Ausführungsbeispielen besitzt die Schirmplatte 10 bevorzugt siebartig beziehungsweise duschkopfartig angeordnete Gasdurchtrittsöffnungen 15, durch die das Prozessgas, welches aus den Gasdurchtrittsöffnungen 12 in den Spalt 17 eingetreten ist, in die Prozesskammer 11 eintreten kann.

Bei dem in den Figuren 1 bis 3 dargestellten Ausführungsbeispiel sind die Gasdurchtrittskanäle 15 der Schirmplatte 10 versetzt zu den Gasdurchtrittskanälen 12 des Gaseinlassorganes 2 angeordnet. Bei den in den Figuren 4 und 5 dargestellten Ausführungsbeispielen fluchten die Gasdurchtrittskanäle 15 mit den Gasdurchtrittskanälen 12.

Die Materialstärke d der Schirmplatte 10 kann im Bereich von 3 bis 12 mm liegen. Bevorzugt kann die Materialstärke d zwischen 5 und 7,5 mm liegen. Die Spalthöhe S kann im Bereich von 0,3 bis 1 mm, bevorzugt bei 0,5 mm liegen. Die Tiefe a der Vertiefung kann im Bereich zwischen 0,46 mm und 0,9 mm liegen. Entsprechend kann auch das Maß der Erhöhung im Bereich zwischen 0,46 und 0,9 mm liegen.

Das Maß der Erhöhung oder der Vertiefung kann gemäß einer Alternativen aber auch zwischen 0,5 und 1,2 mm liegen.

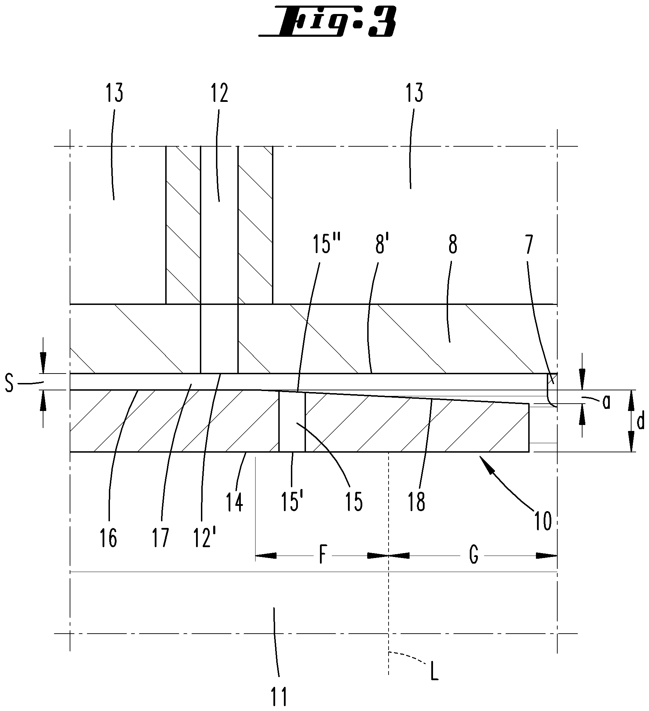

Die Figuren 2 und 3 zeigen mit der Bezugsziffer L eine gedachte Zylindermantelfläche, die sich um den kreisförmigen Suszeptor 3 erstreckt. Der Durchmesser der Zylindermantelfläche L entspricht dem Durchmesser des Suszeptors 3, so dass die Prozesskammer 11 von der Mantelfläche L umgeben ist. Die Schirmplatte 10 bildet eine Ringzone 18 aus, in der die Rückseite 16 geneigt verläuft. Die Ringzone 18 besitzt eine zur Deckenplatte 8 weisende Konusfläche, die sich sowohl über einen radial inneren Bereich F als auch über einen radial äußeren Bereich G erstreckt. Zwischen den beiden Bereichen F und G erstreckt sich die Zylindermantelfläche L, so dass der im Querschnitt keilförmig verlaufende Randbereich der Schirmplatte sich sowohl innerhalb der Prozesskammer 11 als auch außerhalb der Prozesskammer 11 befindet. Der radial innere Bereich F erstreckt sich vertikal oberhalb des Randes 3 des Suszeptors. Der radial außen liegende Bereich G erstreckt sich vertikal oberhalb eines den Suszeptor 3 umgebenden Gasaustrittskanals. An der Randkante der Schirmplatte ist deren Dicke gegenüber ihrer Dicke im Zentralbereich um 0,3 bis 1,2 mm oder um 0,46 bis 0,9 mm vermindert.

Die Rückseite 16 verläuft in einem von der Ringzone 18 umgebenen Zentralbereich in einer Ebene, die parallel zur Gasaustrittsfläche 14 und parallel zur Gasaustrittsfläche 8' verläuft. Der Spalt 17 erstreckt sich somit sowohl über den Zentralbereich als auch über die Ringzone 18 der Schirmplatte 10, so dass aus den Austrittsöffnungen 12' austretendes Prozessgas auch in den Abschnitt des Spaltes 17 strömen kann, der sich über der Ringzone 18 erstreckt.

Im im Querschnitt keilförmigen Bereich der Ringzone 18 befinden sich Gasdurchtrittskanäle 15, so dass in den oberhalb der Ringzone 28 angeordneten Spalt 17 eingetretenes Prozessgas durch eine Austrittsöffnung 15' in die Prozesskammer 11 eintreten kann, die der Ringzone 18 zugeordnet ist.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können, nämlich:

Einen CVD-Reaktor, der dadurch gekennzeichnet ist, dass die Schirmplatte 10 eine von einem Abstand zwischen Gasaustrittsfläche 14 und Rückseitenebene definierte Materialstärke d im Bereich von 3 bis 12 mm aufweist und dass die Schirmplatte 10 von einer von der Deckenplatte) ausgebildeten zweiten Gasaustrittsfläche 8' durch einen von einem Abstand zwischen der zweiten Gasaustrittsfläche 8' und der Rückseitenebene definierten Spalt 17 mit einer Spalthöhe s in einem Bereich von 0,3 bis 1 mm beabstandet ist.

Eine Schirmplatte, dir dadurch gekennzeichnet ist, dass die Schirmplatte 10 eine von einem Abstand zwischen Gasaustrittsfläche 14 und Rückseitenebene definierte Materialstärke d im Bereich von 3 bis 12 mm aufweist und dass die maximale Tiefe der Vertiefung oder die maximale Höhe der Erhöhung gegenüber der Rückseitenebene im Bereich zwischen 0,46 und 0,9 mm liegt oder zwischen 0,5 und 1,2 mm liegt.

Ein Verfahren, dass dadurch gekennzeichnet ist, dass die Schirmplatte 10 eine von einem Abstand zwischen Gasaustrittsfläche 14 und Rückseitenebene definierte Materialstärke d im Bereich von 3 bis 12 mm aufweist und die Rückseite 16 der Schirmplatte 10 von der Deckenplatte 8 durch einen Spalt 17 mit einer Spalthöhe s in einem Bereich von 0,3 bis 1 mm beabstandet ist.

Einen CVD-Reaktor oder eine Schirmplatte oder ein Verfahren, das dadurch gekennzeichnet ist, dass die Vertiefung von der Ringzone 18 ausgebildet ist, deren Rückseitenfläche eine Konusfläche ist, sodass die Schirmplatte 10 in der Ringzone eine zum Rand hin keilförmig abfallende Materialstärke besitzt.

Einen CVD-Reaktor oder ein Verfahren, das dadurch gekennzeichnet ist, dass die Rückseite 16 der Schirmplatte 10 in der Zentralzone eben ist und einen Abstand mit einer konstanten Spalthöhe s zur zweiten Gasaustrittsfläche 8' der Deckenplatte 8 aufweist.

Einen CVD-Reaktor, eine Schirmplatte oder ein Verfahren, das dadurch gekennzeichnet ist, dass mindestens eine Vertiefung 18, 20 oder Erhebung 19 in der Zentralzone und vom Rand der Schirmplatte 10 beabstandet angeordnet ist oder dass die Vertiefungen 18,20 oder Erhebungen 19 der Zentralzone zugeordnet und vom Rand der Schirmplatte 10 beabstandet sind.

Einen CVD-Reaktor oder ein Verfahren, das dadurch gekennzeichnet ist, dass die Vertiefungen 18, 20 oder Erhöhungen 19 lokale Strukturen sind, die sich vertikal oberhalb jeweils eines Substrates 9 erstrecken.

Einen CVD-Reaktor oder ein Verfahren, das dadurch gekennzeichnet ist, dass die Austrittsöffnungen 12' der Deckenplatte 8 mit Gasdurchtrittskanälen 15 der Schirmplatte 10 fluchten oder versetzt zu den Gasdurchtrittskanälen 15 angeordnet sind.

Einen CVD-Reaktor oder ein Verfahren, das dadurch gekennzeichnet ist, dass ein radial äußerster Rand des Suszeptors 3 eine Begrenzungslinie L definiert und ein radial innerer Bereich F der im Querschnitt keilförmig verlaufenden Ringzone 18 radial einwärts der Begrenzungslinie L und ein radial äußerer Bereich G der Ringzone 18 radial auswärts der Begrenzungslinie L verläuft.

Einen CVD-Reaktor oder ein Verfahren, das dadurch gekennzeichnet, dass der radial innere Bereich F und der radial äußere Bereich G radiale Erstreckungen besitzen, die maximal 50 Prozent, 30 Prozent, 20 Prozent oder 10 Prozent voneinander verschieden sind.

Ein Verfahren, das dadurch gekennzeichnet ist, dass durch die Gasaustrittsöffnungen 12' austretendes Prozessgas im Spalt 17 zwischen der zweiten Gasaustrittsfläche 8' und der Rückseite 16 verteilt wird und in einen sich oberhalb der Ringzone 18 erstreckenden Bereich des Spaltes eintritt und durch zumindest einen in der Ringzone 18 angeordneten Gasdurchtrittskanal 15 in die Prozesskammer 11 eintritt.

Einen CVD-Reaktor, der dadurch gekennzeichnet ist, dass sich der Spalt 17 zwischen der zweiten Gasaustrittsfläche 8' und der Rückseite 16 bis über die Ringzone 18 erstreckt, sodass durch die Gasaustrittsöffnungen 12' austretendes Prozessgas im Spalt verteilt wird und durch zumindest einen in der Ringzone 18 angeordneten Gasdurchtrittskanal 15 in die Prozesskammer 11 eintreten kann.

Einen CVD-Reaktor oder ein Verfahren, das dadurch gekennzeichnet ist, dass die Deckenplatte 8 unmittelbar an eine Kühlmittel-Aufnahmekammer 13 angrenzt, durch welche in Austrittsöffnungen 12' mündende Gasdurchtrittskanäle 12 hindurchtreten.

Alle offenbarten Merkmale sind (für sich, aber auch in Kombination untereinander) erfindungswesentlich. Die in jedem Anspruch angegebene Erfindung kann zusätzlich ein oder mehrere der in der vorstehenden Beschreibung, insbesondere mit Bezugsziffern versehene und/oder in der Bezugsziffernliste angegebene Merkmale aufweisen.

**Liste der Bezugszeichen**

| | | | |
|---|---|---|---|
| 1 | CVD-Reaktor | 19 | Erhebung |
| 2 | Gaseinlassorgan | 20 | Vertiefung |
| 2' | Gasverteilvolumen | | |
| 3 | Suszeptor | | |
| 4 | Heizeinrichtung | | |
| 5 | Gasauslass | | |
| 6 | Gaseinlass | | |
| 7 | Begrenzungselement | | |
| 8 | Deckenplatte | S | Spalthöhe |
| 8' | Gasaustrittsfläche | | |
| 9 | Substrat | a | Tiefe |
| 10 | Schirmplatte | d | Materialstärke |
| 11 | Prozesskammer | | |
| 12 | Gasdurchtrittskanal | | |
| 12' | Austrittsöffnung | | |
| 12" | Eintrittsöffnung | | |
| 13 | Kühlmittel-Aufnahmekammer | | |
| 14 | Gasaustrittsfläche | | |
| 15 | Gasdurchtrittskanal | | |
| 15' | Austrittsöffnung | | |
| 15" | Eintrittsöffnung | | |
| 16 | Rückseite | | |
| 17 | Spalt | | |
| 18 | Randbereich/Vertiefung/ Ringzone | | |

## Patentansprüche

1. CVD-Reaktor mit einem einen kreisförmigen Grundriss aufweisenden Gaseinlassorgan, welches eine zu einer Prozesskammer (11) weisende, gekühlte Deckenplatte (8) und einen von einer Heizeinrichtung (4) beheizbaren Suszeptor (3) aufweist, wobei die Deckenplatte (8) Austrittsöffnungen (12') aufweist, und mit einer an die Deckenplatte (8) angrenzenden, einen kreisförmigen Grundriss aufweisenden Schirmplatte (10), die eine Zentralzone, eine die Zentralzone umgebende Ringzone (18), eine zur Deckenplatte (8) weisenden Rückseite (16) und eine erste, ebene, zur Prozesskammer (11) weisende Gasaustrittsfläche (14), in die Gasaustrittsöffnungen (15) münden, aufweist, wobei die Rückseite (16) in der Zentralzone eine parallel zur Gasaustrittsfläche (14) verlaufende Rückseitenebene definiert und wobei die Rückseite (16) Strukturen (18, 19, 20) aufweist zur Beeinflussung der thermischen Ankopplung der Schirmplatte (10) an die Deckenplatte (8) und/ oder zur Beeinflussung des Wärmeflusses durch die Schirmplatte (10), welche Strukturen (18, 19, 20) zumindest eine Erhebung und/oder eine Vertiefung gegenüber der Rückseitenebene ausbilden, **dadurch gekennzeichnet, dass** die Schirmplatte (10) eine von einem Abstand zwischen Gasaustrittsfläche (14) und Rückseitenebene definierte Materialstärke (d) im Bereich von 3 bis 12 mm aufweist und dass die Schirmplatte (10) von einer von der Deckenplatte (8) ausgebildeten zweiten Gasaustrittsfläche (8') durch einen von einem Abstand zwischen der zweiten Gasaustrittsfläche (8') und der Rückseitenebene definierten Spalt (17) mit einer Spalthöhe (s) in einem Bereich von 0,3 bis 1 mm beabstandet ist.

2. Schirmplatte zur Verwendung in einem CVD-Reaktor gemäß Anspruch 1, die einen kreisförmigen Grundriss, eine Zentralzone, eine die Zentralzone umgebende Ringzone (18), bei der Verwendung zu einer Deckenplatte (8) eines Gaseinlassorgans des CVD-Reaktors weisenden Rückseite (16) und eine erste, ebene, bei der Verwendung zu einer Prozesskammer (11) des CVD-Reaktors weisende Gasaustrittsfläche (14), in die Gasaustrittsöffnungen (15) münden, aufweist, wobei die Rückseite (16) in der Zentralzone eine parallel zur Gasaustrittsfläche (14) verlaufende Rückseitenebene definiert und wobei die Rückseite (16) Strukturen (18, 19, 20) aufweist zur Beeinflussung der thermischen Ankopplung der Schirmplatte (10) an die Deckenplatte (8) und/oder zur Beeinflussung des Wärmeflusses durch die Schirmplatte (10), welche Strukturen (18, 19, 20) zumindest eine Erhebung und/oder eine Vertiefung gegenüber der Rückseitenebene ausbilden, **dadurch gekennzeichnet, dass** die Schirmplatte (10) eine von einem Abstand zwischen Gasaustrittsfläche (14) und Rückseitenebene definierte Materialstärke (d) im Bereich von 3 bis 12 mm aufweist und dass die maximale Tiefe der Vertiefung oder die maximale Höhe der Erhöhung gegenüber der Rückseitenebene im Bereich zwischen 0,46 und 0,9 mm oder zwischen 0,5 und 1,2 mm liegt.

3. Verfahren zur Beeinflussung der Temperatur einer zu einer Prozesskammer (11) weisenden ersten Gasaustrittsfläche (14) einer zwischen einer gekühlten Deckenplatte (8) eines CVD-Reaktors (1) angeordneten, einen kreisförmigen Grundriss aufweisenden Schirmplatte (10), die eine Zentralzone, eine die Zentralzone umgebende Ringzone (18), eine zur Deckenplatte (8) weisenden Rückseite (16) und eine erste, ebene, zur Prozesskammer (11) weisende Gasaustrittsfläche (14), in die Gasaustrittsöffnungen (15) münden, aufweist, wobei die Rückseite (16) in ihrer Zentralzone eine parallel zur Gasaustrittsfläche (14) verlaufende Rückseitenebene definiert und wobei ein von einer Heizeinrichtung (4) beheizter Suszeptor (3) zumindest ein Substrat (9) trägt, das wärmebehandelt wird, wobei ein Wärmefluss vom Suszeptor (13) zur Deckenplatte (8) erzeugt wird, wobei die thermische Ankopplung der Schirmplatte (10) an die Deckenplatte (8) und/oder der Wärmefluss durch die Schirmplatte (10) mittels auf der Rückseite (16) der Schirmplatte (10) angeordneten Strukturen (18, 19, 20) beeinflusst wird, wobei die Strukturen (18, 19, 20) zumindest eine Erhebung und/oder eine Vertiefung gegenüber der Rückseitenebene der ausbilden, **dadurch gekennzeichnet, dass** die Schirmplatte (10) eine von einem Abstand zwischen Gasaustrittsfläche (14) und Rückseitenebene definierte Materialstärke (d) im Bereich von 3 bis 12 mm aufweist und die Rückseite (16) der Schirmplatte (10) von der Deckenplatte (8) durch einen Spalt (17) mit einer Spalthöhe (s) in einem Bereich von 0,3 bis 1 mm beabstandet ist.

4. CVD-Reaktor nach Anspruch 1 oder Schirmplatte nach Anspruch 2 oder Verfahren nach Anspruch 3, **dadurch gekennzeichnet, dass** die Vertiefung von der Ringzone (18) ausgebildet ist, deren Rückseitenfläche eine Konusfläche ist, sodass die Schirmplatte (10) in der Ringzone eine zum Rand hin keilförmig abfallende Materialstärke besitzt.

5. CVD-Reaktor nach Anspruch 1 oder 4 oder Verfahren nach Anspruch 3 oder 4, **dadurch gekennzeichnet, dass** die Rückseite (16) der Schirmplatte (10) in der Zentralzone eben ist und einen Abstand mit einer konstanten Spalthöhe (s) zur zweiten Gasaustrittsfläche (8') der Deckenplatte (8) aufweist.

6. CVD-Reaktor nach Anspruch 1, 4 oder 5, Schirmplatte nach Anspruch 3, 4 oder 5 oder Verfahren nach Anspruch 2,3 oder 4 nach einem der vorhergehenden Ansprüche, **dadurch gekennzeichnet, dass** mindestens eine Vertiefung (18, 20) oder Erhebung (19) in der Zentralzone und vom Rand der Schirmplatte (10) beabstandet angeordnet ist oder dass die Vertiefungen (18,20) oder Erhebungen (19) der Zentralzone zugeordnet und vom Rand der Schirmplatte (10) beabstandet sind.

7. CVD-Reaktor nach einem der Ansprüche 1, 4 bis 6 oder Verfahren nach einem der Ansprüche 3 bis 6, **dadurch gekennzeichnet, dass** die Vertiefungen (18, 20) oder Erhöhungen (19) lokale Strukturen sind, die sich vertikal oberhalb jeweils eines Substrates (9) erstrecken.

8. CVD-Reaktor nach einem der Ansprüche 1, 4 bis 7 oder Verfahren nach einem der Ansprüche 3 bis 7, **dadurch gekennzeichnet, dass** die Austrittsöffnungen (12') der Deckenplatte (8) mit Gasdurchtrittskanälen (15) der Schirmplatte (10) fluchten oder versetzt zu den Gasdurchtrittskanälen (15) angeordnet sind.

9. CVD-Reaktor oder Verfahren nach Anspruch 4, **dadurch gekennzeichnet, dass** ein radial äußerster Rand des Suszeptors (3) eine Begrenzungslinie (L) definiert und ein radial innerer Bereich (F) der im Querschnitt keilförmig verlaufenden Ringzone (18) radial einwärts der Begrenzungslinie (L) und ein radial äußerer Bereich (G) der Ringzone (18) radial auswärts der Begrenzungslinie (L) verläuft.

10. CVD-Reaktor oder Verfahren nach Anspruch 9, **dadurch gekennzeichnet, dass** der radial innere Bereich (F) und der radial äußere Bereich (G) radiale Erstreckungen besitzen, die maximal 50 Prozent, 30 Prozent, 20 Prozent oder 10 Prozent voneinander verschieden sind.

11. Verfahren nach einem der Ansprüche 3 bis 10, **dadurch gekennzeichnet, dass** durch die Gasaustrittsöffnungen (12') austretendes Prozessgas im Spalt (17) zwischen der zweiten Gasaustrittsfläche (8') und der Rückseite (16) verteilt wird und in einen sich oberhalb der Ringzone (18) erstreckenden Bereich des Spaltes eintritt und durch zumindest einen in der Ringzone (18) angeordneten Gasdurchtrittskanal (15) in die Prozesskammer (11) eintritt.

12. CVD-Reaktor nach einem der Ansprüche 1, 4 bis 11, **dadurch gekennzeichnet, dass** sich der Spalt (17) zwischen der zweiten Gasaustrittsfläche (8') und der Rückseite (16) bis über die Ringzone (18) erstreckt, sodass durch die Gasaustrittsöffnungen (12') austretendes Prozessgas im Spalt verteilt wird und durch zumindest einen in der Ringzone (18) angeordneten Gasdurchtrittskanal (15) in die Prozesskammer (11) eintreten kann.

13. CVD-Reaktor nach einem der Ansprüche 1, 4 bis 12 oder Verfahren nach einem der Ansprüche 9 bis 12, **dadurch gekennzeichnet, dass** die Deckenplatte (8) unmittelbar an eine Kühlmittel-Aufnahme-kammer (13) angrenzt, durch welche in Austrittsöffnungen (12') mündende Gasdurchtrittskanäle (12) hindurchtreten.

## Claims

1. A CVD reactor with a gas inlet member having a circular outline, which has a cooled ceiling panel (8) facing towards a process chamber (11), and a susceptor (3), which can be heated by a heating device (4), wherein the ceiling panel (8) has outlet openings (12'), and with a shield plate (10), adjacent to the ceiling panel (8), having a circular outline, which shield plate has a central zone, an annular zone (18) surrounding the central zone, a rear face (16) facing towards the ceiling panel (8), and a first, plane gas outlet surface (14) facing towards the process chamber (11), into which gas outlet openings (15) lead, wherein the rear face (16) in the central zone defines a rear face plane extending parallel to the gas outlet surface (14), and wherein the rear face (16) has structures (18, 19, 20) for purposes of influencing the thermal coupling of the shield plate (10) to the ceiling panel (8), and/or for purposes of influencing the heat flow through the shield plate (10), which structures (18, 19, 20) form at least one elevation, and/or one depression, with respect to the rear face plane, **characterized in that** the shield plate (10) has a material thickness (d), defined by a distance between the gas outlet surface (14) and the rear face plane in the range from 3 to 12 mm, and **in that** the shield plate (10) is spaced apart from a second gas outlet surface (8') formed by the ceiling panel (8) by a gap (17), defined by a distance between the second gas outlet surface (8') and the rear face plane, with a gap height (S) in a range from 0.3 to 1 mm.

2. A shield plate for use in a CVD reactor according to Claim 1, which has a circular outline, a central zone, an annular zone (18) surrounding the central zone, a rear face (16) which, in use, faces towards a ceiling panel (8) of a gas inlet member of the CVD reactor, and a first, plane gas outlet surface (14), which, in use, faces towards a process chamber (11) of the CVD reactor, and into which gas outlet openings (15) lead, wherein the rear face (16) in the central zone defines a rear face plane extending parallel to the gas outlet surface (14), and wherein the rear face (16) has structures (18, 19, 20) for purposes of influencing the thermal coupling of the shield plate (10) to the ceiling panel (8), and/or for purposes of influencing the heat flow through the shield plate (10), which structures (18, 19, 20) form at least one elevation, and/or one depression, with respect to the rear face plane, **characterized in that** the shield plate (10) has a material thickness (d) defined by a distance between the gas outlet surface (14) and the rear face plane in the range from 3 to 12 mm, and **in that** the maximum depth of the depression or the maximum height of the elevation relative to the rear face plane is in the range between 0.46 and 0.9 mm, or between 0.5 and 1.2 mm.

3. A method for purposes of influencing the temperature of a first gas outlet surface (14), facing towards a process chamber (11), of a shield plate (10) which is arranged between a cooled ceiling panel (8) of a CVD reactor (1) and has a circular outline, which has a central zone, an annular zone (18) surrounding the central zone, a rear face (16) facing towards the ceiling panel (8) and a first, plane gas outlet surface (14) facing towards the process chamber (11), into which gas outlet openings (15) lead, wherein the rear face (16) defines in its central zone a rear face plane extending parallel to the gas outlet surface (14) and wherein a susceptor (3) heated by a heating device (4) carries at least one substrate (9) which is heat-treated, wherein a heat flow is generated from the susceptor (13) to the ceiling panel (8), wherein the thermal coupling of the shield plate (10) to the ceiling panel (8), and/or the heat flow through the shield plate (10) is influenced by means of structures (18, 19, 20) arranged on the rear face (16) of the shield plate (10), wherein the structures (18, 19, 20) form at least one elevation, and/or one depression, with respect to the rear face plane, **characterized in that** the shield plate (10) has a material thickness (d), defined by a distance between the gas outlet surface (14) and the rear face plane, in the range from 3 to 12 mm, and the rear face (16) of the shield plate (10) is spaced apart from the ceiling panel (8) by a gap (17), with a gap height (S) in the range from 0.3 to 1 mm.

4. The CVD reactor according to Claim 1, or the shield plate according to Claim 2, or the method according to Claim 3, **characterized in that** the depression is formed by the annular zone (18), the surface of the rear face of which is a conical surface, such that in the annular zone the shield plate (10) has a material thickness that decreases in the form of a wedge towards the edge.

5. The CVD reactor according to Claim 1 or 4, or the method, according to Claim 3 or 4, **characterized in that** the rear face (16) of the shield plate (10) is plane in the central zone, and has a distance with a constant gap height (S) from the second gas outlet surface (8') of the ceiling panel (8).

6. The CVD reactor according to Claim 1, 4 or 5, the shield plate according to Claim 3, 4 or 5, or the method according to Claim 2, 3 or 4, **characterized in that** at least one depression (18, 20), or elevation (19), is arranged in the central zone, and spaced apart from the edge of the shield plate (10), or **in that** the depressions (18, 20), or elevations (19), are assigned to the central zone, and are spaced apart from the edge of the shield plate (10).

7. The CVD reactor according to one of the claims 1, 4 to 6, or the method, according to one of the claims 3 to 6, **characterized in that** the depressions (18, 20), or elevations (19), are local structures, which in each case extend vertically above a respective substrate (9).

8. The CVD reactor according to one of the claims 1, 4 to 7, or the method, according to one of the claims 3 to 7, **characterized in that** the outlet openings (12') of the ceiling panel (8) are aligned with gas passageways (15) of the shield plate (10), or are arranged offset from the gas passageways (15).

9. The CVD reactor, or the method, according to Claim 4, **characterized in that**, a radially outermost edge of the susceptor (3) defines a boundary line (L), and a radially inner region (F) of the annular zone (18), which is wedge-shaped in cross-section, extends radially inwards of the boundary line (L), and a radially outer region (G) of the annular zone (18) extends radially outwards of the boundary line (L).

10. The CVD reactor, or the method, according to Claim 9, **characterized in that** the radially inner region (F) and the radially outer region (G) have radial extents that differ from each other by a maximum of 50 percent, of 30 percent, of 20 percent, or of 10 percent.

11. The method according to one of the claims 3 to 10, **characterized in that** process gas exiting through the gas outlet openings (12') is distributed in the gap (17) between the second gas outlet surface (8') and the rear face (16), and enters into a region of the gap extending above the annular zone (18), and enters into the process chamber (11) through at least one gas passage channel (15) arranged in the annular zone (18).

12. The CVD reactor according to one of the claims 1, 4 to 11, **characterized in that** the gap (17) between the second gas outlet surface (8') and the rear face (16) extends beyond the annular zone (18), such that process gas exiting through the gas outlet openings (12') is distributed in the gap, and can enter into the process chamber (11) through at least one gas passage channel (15) arranged in the annular zone (18).

13. The CVD reactor according to one of the claims 1, 4 to 12 or the method according to one of the claims 9 to 12, **characterized in that** the ceiling panel (8) is directly adjacent to a coolant accommodation chamber (13), through which pass gas passageways (12), leading into outlet openings (12').

## Revendications

1. Réacteur CVD avec un organe d'entrée de gaz comportant un profil d'ensemble de forme circulaire, lequel comporte une plaque de couverture (8) refroidie, dirigée vers une chambre de traitement (11) et un suscepteur (3) chauffable par un dispositif de chauffage (4), sachant que la plaque de couverture (8) comporte des ouvertures de sortie (12') et avec une plaque formant écran (10) contigüe à la plaque de couverture (8), comportant un profil d'ensemble de forme circulaire, qui comporte une zone centrale, une zone annulaire (18) entourant la zone centrale, une face arrière (16) dirigée vers la plaque de couverture (8) et une première surface de sortie de gaz (14) plane, dirigée vers la chambre de traitement (11), dans laquelle débouchent des ouvertures de sortie de gaz (15), sachant que la face arrière (16) définit dans la zone centrale un plan de face arrière passant parallèlement à la surface de sortie de gaz (14) et sachant que la face arrière (16) comporte des structures (18, 19, 20) pour influencer le couplage thermique de la plaque formant écran (10) à la plaque de couverture (8) et/ou pour influencer le flux thermique à travers la plaque formant écran (10), lesquelles structures (18, 19, 20) constituent au moins une élévation et/ou une cavité par rapport au plan de face arrière, **caractérisé en ce que** la plaque formant écran (10) comporte une épaisseur de matériau (d) définie par un intervalle entre la surface de sortie de gaz (14) et le plan de face arrière dans la plage de 3 à 12 mm et **en ce que** la plaque formant écran (10) est éloignée d'une deuxième surface de sortie de gaz (8') constituée par la plaque de couverture (8) par un interstice (17) défini par un intervalle entre la deuxième surface de sortie de gaz (8') et le plan de face arrière avec une hauteur d'interstice (s) dans une plage de 0,3 à 1 mm.

2. Plaque formant écran pour utilisation dans un réacteur CVD selon la revendication 1, qui comporte un profil d'ensemble de forme circulaire, une zone centrale, une zone annulaire (18) entourant la zone centrale, une face arrière (16) dirigée pour l'utilisation vers une plaque de couverture (8) d'un organe d'entrée de gaz du réacteur CVD et une première surface de sortie de gaz (14) plane, dirigée pour l'utilisation vers une chambre de traitement (11) du réacteur CVD, dans laquelle débouchent des ouvertures de sortie de gaz (15), sachant que la face arrière (16) définit dans la zone centrale un plan de face arrière passant parallèlement à la surface de sortie de gaz (14) et sachant que la face arrière (16) comporte des structures (18, 19, 20) pour influencer le couplage thermique de la plaque formant écran (10) à la plaque de couverture (8) et/ou pour influencer le flux thermique à travers la plaque formant écran (10), lesquelles structures (18, 19, 20) constituent au moins une élévation et/ou une cavité par rapport au plan de face arrière, **caractérisé en ce que** la plaque formant écran (10) comporte une épaisseur de matériau (d) définie par un intervalle entre la surface de sortie de gaz (14) et le plan de face arrière dans la plage de 3 à 12 mm et **en ce que** la profondeur maximale de la cavité ou la hauteur maximale de l'élévation par rapport au plan de face arrière se situent dans la plage variant entre 0,46 et 0,9 mm ou entre 0,5 et 1,2 mm.

3. Procédé destiné à influencer la température d'une première surface de sortie de gaz (14) dirigée vers une chambre de traitement (11) d'une plaque formant écran (10) disposée entre une plaque de couverture (8) refroidie d'un réacteur CVD (1), comportant un profil d'ensemble de forme circulaire, qui comporte une zone centrale, une zone annulaire (18) entourant la zone centrale, une face arrière (16) dirigée vers la plaque de couverture (8) et une première surface de sortie de gaz (14) plane dirigée vers la chambre de traitement (11), dans laquelle débouchent des ouvertures de sortie de gaz (15), sachant que la face arrière (16) définit dans sa zone centrale un plan de face arrière passant parallèlement à la surface de sortie de gaz (14) et sachant qu'un suscepteur (3) chauffé par un dispositif de chauffage (4) porte au moins un substrat (9), qui est traité thermiquement, sachant qu'un flux thermique est produit par le suscepteur (13) vers la plaque de couverture (8), sachant que le couplage thermique de la plaque formant écran (10) à la plaque de couverture (8) et/ou le flux thermique à travers la plaque formant écran (10) est influencé au moyen de structures (18, 19, 20) disposées sur la face arrière (16) de la plaque formant écran (10), sachant que les structures (18, 19, 20) forment au moins une élévation et/ou une cavité par rapport au plan de face arrière, **caractérisé en ce que** la plaque formant écran (10) comporte une épaisseur de matériau (d) définie par un intervalle entre la surface de sortie de gaz (14) et le plan de face arrière dans une plage de 3 à 12 mm et la face arrière (16) de la plaque formant écran (10) est éloignée de la plaque de couverture (8) par un interstice (17) avec une hauteur d'interstice (s) dans une plage de 0,3 à 1 mm.

4. Réacteur CVD selon la revendication 1 ou plaque formant écran selon la revendication 2 ou procédé selon la revendication 3, **caractérisé en ce que** la cavité est constituée par la zone annulaire (18), dont la surface de la face arrière est une surface conique de telle manière que la plaque formant écran (10) possède dans la zone annulaire une épaisseur de matériau chutant en forme de coin vers le bord.

5. Réacteur CVD selon la revendication 1 ou 4 ou procédé selon la revendication 3 ou 4, **caractérisé en ce que** la face arrière (16) de la plaque formant écran (10) est plane dans la zone centrale et comporte un intervalle avec une hauteur d'interstice constante (s) par rapport à la deuxième surface de sortie de gaz (8') de la plaque de couverture (8).

6. Réacteur CVD selon la revendication 1, 4 ou 5, plaque formant écran selon la revendication 3, 4 ou 5 ou procédé selon la revendication 2, 3 ou 4 selon l'une quelconque des revendications précédentes, **caractérisé en ce qu'**au moins une cavité (18, 20) ou une élévation (19) est située dans la zone centrale et à distance du bord de la plaque formant écran (10) ou **en ce que** les cavités (18, 20) ou les élévations (19) sont attribuées à la zone centrale et sont à distance du bord de la plaque formant écran (10).

7. Réacteur CVD selon l'une quelconque des revendications 1, 4 à 6 ou procédé selon l'une quelconque des revendications 3 à 6, **caractérisé en ce que** les cavités (18, 20) ou les élévations (19) sont des structures locales, qui s'étendent verticalement au-dessus respectivement d'un substrat (9).

8. Réacteur CVD selon l'une quelconque des revendications 1, 4 à 7, ou procédé selon l'une quelconque des revendications 3 à 7, **caractérisé en ce que** les ouvertures de sortie (12') de la plaque de couverture (8) avec les conduits de passage de gaz (15) de la plaque formant écran (10) sont disposés de façon affleurante ou déportée par rapport aux conduits de passage de gaz (15).

9. Réacteur CVD ou procédé selon la revendication 4, **caractérisé en ce qu'**un bord radialement le plus extérieur du suscepteur (3) définit une ligne de délimitation (L) et une zone radialement intérieure (F) de la zone annulaire (18) passant en forme de coin dans la section passe radialement vers l'intérieur de la ligne de délimitation (L) et une zone radialement extérieure (G) de la zone annulaire (18) passe radialement vers l'extérieur de la ligne de délimitation (L).

10. Réacteur CVD ou procédé selon la revendication 9, **caractérisé en ce que** la zone radialement interne (F) et la zone radialement extérieure (G) possèdent des extensions radiales, qui sont différentes l'une de l'autre au maximum de 50 pour cent, 30 pour cent, 20 pour cent ou 10 pour cent.

11. Procédé selon l'une quelconque des revendications 3 à 10, **caractérisé en ce que** du gaz de traitement sortant à travers les ouvertures de sortie de gaz (12') est réparti dans l'interstice (17) entre la deuxième surface de sortie de gaz (8') et la face arrière (16) et entre dans une zone de l'interstice s'étendant au-dessus de la zone annulaire (18) et entre dans la chambre de traitement (11) par au moins un conduit de passage de gaz (15) disposé dans la zone annulaire (18).

12. Réacteur CVD selon l'une quelconque des revendications 1, 4 à 11, **caractérisé en ce que** l'interstice (17) s'étend entre la deuxième surface de sortie de gaz (8') et la face arrière (16) jusque sur la zone annulaire (18) de telle manière que du gaz de traitement sortant par les ouvertures de sortie de gaz (12') est réparti dans l'interstice et peut entrer dans la chambre de traitement (11) par au moins un conduit de passage de gaz (15) disposé dans la zone annulaire (18).

13. Réacteur CVD selon l'une quelconque des revendications 1, 4 à 12 ou procédé selon l'une quelconque des revendications 9 à 12, **caractérisé en ce que** la plaque de couverture (8) est directement contigüe à une chambre de logement de réfrigérant (13) à travers laquelle passent des conduits de passage de gaz (12) débouchant dans les ouvertures de sortie (12').
